Europäisches Patentamt

**European Patent Office**

**Office européen des brevets**

(11) Numéro de publication: **0 260 173 B1**

# (12) FASCICULE DE BREVET EUROPEEN

(45) Date de publication de fascicule du brevet: **13.01.93** (51) Int. Cl.⁵: **H01L  41/08**, G01V 1/20

(21) Numéro de dépôt: **87401857.5**

(22) Date de dépôt: **10.08.87**

(54) **Hydrophones piezo-électriques de sensibilité accrue.**

(30) Priorité: **27.08.86 FR 8612205**

(43) Date de publication de la demande:
**16.03.88 Bulletin  88/11**

(45) Mention de la délivrance du brevet:
**13.01.93 Bulletin  93/02**

(84) Etats contractants désignés:
**BE DE GB IT NL**

(56) Documents cités:
**WO-A-81/02223          DE-A- 3 212 618**
**DE-A- 3 248 222          FR-A- 2 271 733**
**US-A- 3 798 474          US-A- 4 234 813**

(73) Titulaire: **INSTITUT FRANCAIS DU PETROLE**
**4, Avenue de Bois Préau**
**F-92502 Rueil-Malmaison(FR)**

(72) Inventeur: **Beauducel, Claude**
**8, rue Talon**
**F-60119 Henonville(FR)**
Inventeur: **Gautier, Thierry**
**54, quai Maréchal Joffre**
**F-77000 Melun(FR)**

Rank Xerox (UK) Business Services

EP 0 260 173 B1

**Description**

L'invention a pour objet des hydrophones piézo-électriques de sensibilité accrue.

Les hydrophones piézo électriques comportent généralement un ou plusieurs éléments sensibles constitués chacun d'un substrat possédant des propriétés piézo-électriques et de deux électrodes disposées de part et d'autre.

Le substrat peut être réalisé sous la forme de disques en céramique de dimensions relativement petites, inclus dans un boîtier rigide pourvu d'une ou plusieurs faces transparentes aux ondes acoustiques. Le brevet français n° 2.122.675 montre la réalisation d'un hydrophone piézo-électrique où un, et de préférence deux disques en céramique, muni chacun de ses électrodes, sont fixés sur deux plaques souples en regard l'une de l'autre. Une au moins des plaques est pourvue d'une partie périphérique rigide plus épaisse venant en appui contre l'autre.

Le substrat peut aussi être réalisé sous la forme de rubans ou de plaques souples réalisés à partir d'un matériau synthétique plastique auquel un traitement confère des propriétés piézo-électriques. On utilise généralement des matériaux tels que le PVDF (polyfluorure de vinylidène), le polyéthylène, le PTFE (polytétrafluorure d'éthylène) etc.

Les éléments sensibles souples s'emploient le plus souvent sous la forme de rubans ou de bandes disposés sur un support plan ou bien enroulés en hélice autour d'un noyau cylindrique. On les combine généralement par deux. En les disposant de part et d'autre d'un support avec des polarités opposées et, en les connectant électriquement, on obtient une compensation des tensions parasites naissant des flexions du support et des accélérations.

Par l'emploi de bandes souples, on peut construire des hydrophones continus de longueur relativement grande qui réalisent des filtrages en nombre d'onde. Incorporés dans des flûtes sismiques remorquées par un navire, ils permettent notamment de filtrer certains bruits parasites et de faciliter la réception des signaux renvoyés par des discontinuités du sous-sol immergé, en réponse à des ondes sismiques émises par une source remorquée.

Des éléments sensibles de ce type sont décrits dans le brevet français n° 2.271.733, le brevet français n° 2.145.099 auquel correspond le brevet US-3.798.474, et la demande de brevet français E.N. 86/09880.

Les éléments sensibles sont très souvent constitués à partir de rubans de faible épaisseur (de l'ordre de quelques dizaines de $\mu$m) dont la sensibilité est relativement faible, en général inférieure à 1V/bar (1 bar = $10^5$ Pa). Pour accroître la sensibilité des capteurs réalisés à partir de tels éléments sensibles, on est conduit à en combiner plusieurs électriquement, ce qui accroît le prix de revient et complique la fabrication.

L'invention concerne un hydrophone de sensibilité accrue réalisé à partir d'éléments sensibles comportant chacun un film mince piézo-électrique en matériau synthétique plastique associé sur chacune de ses faces à un film conducteur uniforme constituant une électrode, l'élément sensible étant appliqué sur un support localement rigide en matériau diélectrique.

Il est caractérisé en ce qu'au moins une de ses faces dudit support est pourvue d'une distribution de petites cavités, l'élément sensible étant disposé contre cette surface, la profoudeur de chaque des cavités étant choisie pour que l'élément sensible vienne s'appuyer sans dommage contre le fond des cavités grand des contraintes exercées dépassent un seuil déterminé par les contraintes limites qui provoquent une rupture de l'élément sensible. Les dimensions des parties en creux sont choisies pour limiter les déformations subies par l'élément sensible vers l'intérieur de celles-ci sous l'effet des contraintes qui lui sont appliquées, à des valeurs compatibles avec les caractéristiques du film utilisé.

La distribution de cavités peut être obtenue par l'utilisation d'une structure alvéolée, par enlèvement de matière, par estampage etc.

L'utilisation d'un support de surface inégale a pour effet que le film subit au niveau des parties en creux, soit des flexions, soit des étirements. Ce sont là des modes de fonctionnement où la sensibilité des éléments sensibles est beaucoup plus élevée que dans le cas normal où ils subissent des compressions planes perpendiculairement à leurs faces.

Par un choix judicieux des dimensions des parties en creux, on peut éviter les déformations irréversibles des éléments sensibles et donc construire des capteurs adaptés à supporter des conditions sévères d'utilisation.

D'autres caractéristiques et avantages de l'hydrophone selon l'invention du dispositif apparaîtront à la lecture de la description de plusieurs modes de réalisation donnés à titre d'exemples non limitatifs, en se référant aux dessins annexés où :
- la figure 1 représente, vu en coupe, un élément sensible;
- la figure 2 représente un élément sensible appliqué sur un support dont la surface est pourvue d'une distribution régulière de cavités;

2

- la figure 3 représente une variante de la figure 1 où la surface du support est alvéolée;
- la figure 4 représente, vu en épaisseur, un support dont les faces opposées sont également pourvues de cavités et contre lesquelles sont appliqués deux éléments sensibles;
- la figure 5 représente un mode de réalisation d'un capteur de forme cylindrique obtenu par enroulement d'une ensemble sensible tel que celui de la figure 2; et
- la figure 6 représente un mode de réalisation où le support de l'élément sensible est annelé.

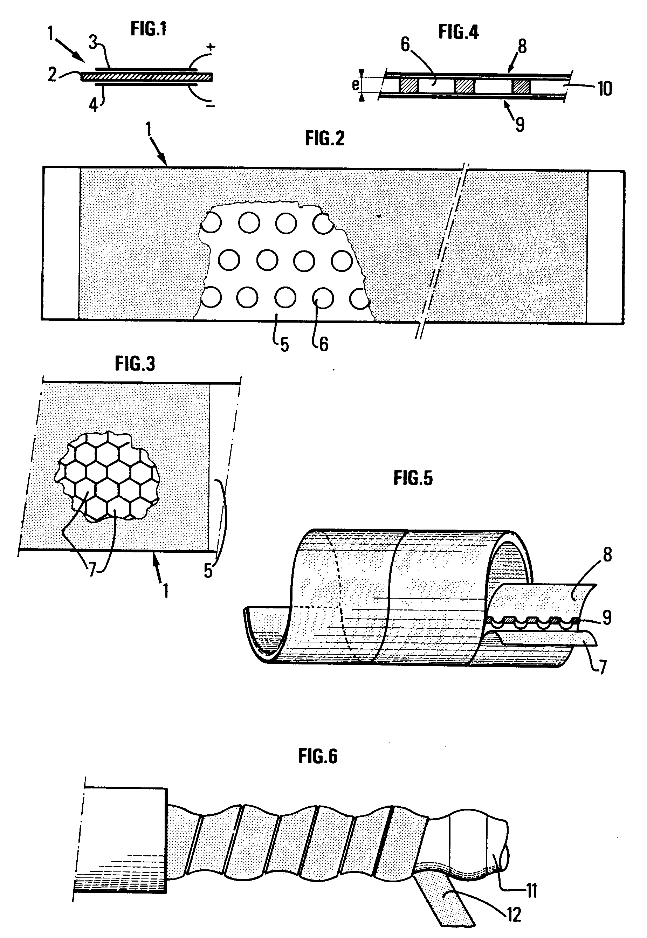

L'élément sensible 1 représenté à la figure 1 comporte un film mince 2 réalisé en un matériau tel que le PVDF par exemple auquel un traitement a donné des propriétés piézo-électriques. Ce type de film est souvent disponible sous la forme d'un ruban de un ou plusieurs centimètres de largeur. De part et d'autre du film, sont disposées deux électrodes 3, 4 permettant de collecter les charges électriques créées par les déformations du film 2 en réponse aux contraintes appliquées.

L'élément sensible 1 est appliqué (fig. 2) contre un support 5 localement rigide pourvu de parties en creux 6 réparties régulièrement sur l'une au moins des surfaces. Ce support est réalisé par exemple en un matériau synthétique du type PTFE. Sa rigidité locale est suffisante pour qu'il puisse supporter sans déformation sensible les contraintes appliquées à l'élément sensible perpendiculairement à ses faces, mais il est suffisamment flexible pour pouvoir être enroulé.

On observe que la sensibilité d'un élément sensible appliqué sur un support dont la surface est inégale est beaucoup plus grande que celle qu'il peut avoir lorsque la surface du support est unie. Des mesures montrent que l'on peut facilement multiplier la sensibilité par un facteur 4 ou 5 et même plus. L'augmentation de la sensibilité est due au fait que le film piézo-électrique travaille en flexion en face de chacune des parties creuses du support. Pour accroître la sensibilité du capteur, on utilise de préférence des supports où la surface totale des parties en creux est la plus grande possible. Ceci est réalisé en augmentant soit la surface unitaire des parties en creux soit leur densité par unité de surface. Suivant un mode particulier de réalisation (fig. 3), on utilise un support 5 dont les surfaces comportent des alvéoles 7 (structure en nid d'abeille) qui permet d'obtenir à la fois une grande densité de parties creuses et une rigidité suffisante sur leur pourtour.

L'optimisation recherchée de la sensibilité des éléments sensibles doit cependant rester compatible avec leur résistance mécanique.

On montre que le module de flexion D d'un film s'exprime par la relation :

$$D = \frac{E.h^3}{12/(1-\alpha^2)} \qquad (1)$$

où E et $\alpha$ représentent respectivement le module de Young et le coefficient de Poisson et h représente l'épaisseur du film.

Compte tenu de la relation (1), la flèche f c'est-à-dire l'enfoncement du film à l'intérieur d'un trou circulaire de rayon a s'exprime par la relation :

$$F = \frac{K \; a^2}{D} \qquad (2)$$

où K est un coefficient de proportionnalité.

Les contraintes radiales et tangentielles subies par un film lorsqu'il fléchit dans un creux, dépendent de son épaisseur, du diamètre des creux et de la pression exercée et varient du centre à la périphérie.

On montre par exemple que la contrainte radiale CR et la contrainte tangentielle CT subies par un film fixé à la périphérie d'un creux de rayon a, à une distance r du centre de celui-ci s'expriment par les relations :

$$CR = \frac{(k_1 \, a^2 - k_2 \, r)}{h} \cdot P \qquad\qquad (3)$$

$$CT = \left( \frac{k_1}{h} \cdot a^2 - \frac{k_3 \, r}{h^2} \right) \cdot P$$

ou $k_1$, $k_2$, $k_3$ sont des coefficients de proportionnalité et P représente la pression appliquée.

Compte tenu des caractéristiques mécaniques du film on peut donc connaître les contraintes limites qui provoquent sa rupture et donc fixer les contraintes maximales compatibles avec la sécurité. De ce fait, on peut fixer les dimensions maximales à donner aux parties creuses ainsi que la plage d'utilisation du capteur constitué avec l'élément sensible. Pour un hydrophone, on détermine une profondeur maximale d'immersion et/ou une dynamique de variation de la pression mesurée.

On choisit de préférence la profondeur des cavités, de manière que l'élément sensible fonctionne en deçà de ses limites de sécurité. Lorsqu'elle sont dépassées, le film sensible vient s'appuyer contre le fond des parties en creux et subit sans dommage les contraintes excessives.

La fabrication d'un support plat dont l'une des faces présente des inégalités de relief peut être effectuée par tout procédé connu : moulage, perforation ou estampage, tissage ou tressage, photogravure, ou encore en utilisant une substance présentant naturellement des inégalités de surface à répartition homogène etc. Suivant le mode de réalisation de la figure 4, un hydrophone peut être constitué en disposant deux éléments sensibles 8, 9 de part et d'autre d'un support plat 10 dont les faces opposées présentent des inégalités de relief. Les parties en creux 6, de part et d'autre du support peuvent être séparées les unes des autres. Mais si l'épaisseur e du support est inférieure ou égale à deux fois la flèche maximale qu'un film sensible peut prendre en fléchissant, on peut utiliser à cet effet un ruban plat ajouré ou percé de part en part. Sous l'effet des contraintes, les deux éléments sensibles 8, 9 se creusent l'un vers l'autre. Si les déformations deviennent excessives, les deux éléments sensibles viennent alors en butée l'un contre l'autre.

Suivant une disposition déjà connue par le brevet français 2.145.099 précité, les deux éléments sensibles sont disposés de part et d'autre du support avec des polarités opposées. De cette manière les charges électriques créées par une flexion du support se compensent.

L'application d'un élément sensible sur un support peut se faire par collage au moyen d'une colle conductrice. On peut procéder de deux façons. La première consiste à coller l'élément sensible seulement sur son pourtour de manière qu'il soit libre à la périphérie de chacune des parties en creux. La seconde consiste à coller l'élément sensible sur toute sa surface, de manière que l'élément sensible soit tenu à la périphérie de toutes les cavités. Le collage de l'élément sensible seulement sur le pourtour est plus simple à réaliser mais augmente les contraintes appliquées au film au niveau de chaque partie creuse. Les contraintes sont moins fortes dans le cas d'un collage sur toute la surface, ce qui a pour effet de reculer les limites de sécurité. De plus la colle conductrice maintient mieux la continuité électrique et rend donc le capteur moins sensible aux détériorations mécaniques pouvant se produire du fait des déformations.

Suivant le mode de réalisation de la figure 5, on peut donner au support plat une configuration cylindrique. Le support perforé 10 associé à ses deux éléments sensibles 8, 9 est enroulé sur lui-même en hélice à spires jointives qui sont soudées bord à bord. Cet agencement donne des résultats particulièrement bons pour la compensation des flexions et des accélérations.

Dans le mode de réalisation de la figure 6, le support est constitué d'un tube annelé ou cannelé 11 déformable principalement suivant son axe. Au moins un élément sensible 12 est enroulé en hélice à spires jointives ou non jointives. Suivant un agencement décrit dans la demande de brevet français précitée EN 86/09880, on pourra aussi superposer sur le support annelé 11 deux éléments sensibles enroulés en hélices de sens contraires de manière à obtenir une meilleure compensation des flexions. Le capteur ainsi constitué est très sensible aux contraintes qui peuvent être exercées suivant sa direction de déformation principale. L'enroulement en hélice favorise l'étirement des films sensibles suivant toutes les directions et ceci accroît la sensibilité du capteur. Cet agencement convient particulièrement pour la réalisation de jauges de contrainte.

On ne sortirait pas du cadre de l'invention en adoptant d'autres types de support de formes diverses tels qu'un support cylindrique dont la surface présente des inégalités de relief par exemple.

**Revendications**

1. Hydrophone piézo-électrique comportant au moins un élément sensible (1) constitué d'un film mince (2) piézo-électrique en matériau synthétique plastique associé sur chacune de ses faces, à un film conducteur uniforme constituant une électrode (3, 4), l'élément sensible étant appliqué sur un support (5) localement rigide en matériau diélectrique, caractérisé en ce qu'au moins une de ses faces dudits support (5) est pourvue d'une distribution de petites cavités, l'élément sensible étant disposé contre ladite face, la profondeur de chacune des cavités (6, 7) étant choisies pour que l'élément sensible vienne s'appuyer sans dommage contre le fond des cavités quand des contraintes exercées dépassent un seuil déterminé par les contraintes qui provoquent une rupture de l'élément sensible.

2. Hydrophone selon la revendication 1, ledit support a une structure en nid d'abeille.

3. Hydrophone selon la revendication 1, caractérisé en ce que lesdites cavités sont réalisées par enlèvement de matière.

4. Hydrophone selon la revendication 1, caractérisé en ce que lesdites cavités sont réalisées par estampage.

5. Hydrophone selon l'une des revendications précédentes, caractérisé en ce que le support en enroulé en hélice à spires jointives.

6. Hydrophone selon la revendication 1 ou 5, caractérisé en ce qu'il comporte deux éléments sensibles disposés respectivement en contact des faces d'un même support, ledit support étant ajouré et son épaisseur étant choisie pour que les éléments sensibles viennent s'appuyer l'un contre l'autre quand les contraintes exercées dépassent un seuil déterminé.

**Claims**

1. Piezo-electric hydrophone comprising at least one sensitive element (1) prepared from a thin piezo-electric film (2) of synthetic plastic material associated, on each of its faces, with a uniform conductive film constituting an electrode (3,4), the sensitive element being applied to a locally rigid support (5) of dielectric material, characterised in that at least one of the faces of the said support (5) is provided with an arrangement of small cavities, the sensitive element being located against the said face, the depth of each of the cavities (6,7) being chosen so that the sensitive element is supported without damage against the base of the cavities when the stresses exerted exceed a threshold determined by the stresses which cause a rupture of the sensitive element.

2. Hydrophone in accordance with claim 1, the said support having a honeycomb structure.

3. Hydrophone in accordance with claim 1, characterised in that the said cavities are produced by the removal of material.

4. Hydrophone in accordance with claim 1, characterised in that the said cavities are produced by a forming process.

5. Hydrophone in accordance with one of the preceding claims, characterised in that the support is wound in the form of contiguous spiral turns.

6. Hydrophone in accordance with claim 1 or 5, characterised in that it comprises two sensitive elements located respectively in contact with the faces of the same support, the said support being perforated and its thickness being chosen so that the sensitive elements are supported against each other when the stresses exerted exceed a determined threshold.

**Patentansprüche**

1. Piezoelektrisches Hydrophon mit wenigstens einem empfindlichen Element (1), das durch einen dünnen piezoelektrischen Film (2) aus synethetischem, plastischem Material gebildet ist, der auf jeder seiner Flächen einem eine Elektrode (3, 4) bildenden Film zugeordnet ist, wobei das empfindliche Element auf einen lokal steifen Träger (5) aus dielektrischem Material aufgebracht ist, **dadurch gekennzeichnet**, daß wenigstens eine seiner Flächen dieses Trägers (5) mit einer Verteilung kleiner Hohlräume versehen ist, wobei das empfindliche Element gegen diese Fläche angeordnet ist, wobei die Tiefe jeder der Hohlräume (6, 7) gewählt ist, damit das empfindliche Element ohne Schaden gegen den Boden der Hohlräume in Abstützung kommt, wenn die ausgeübten Beanspruchungen einen Schwellenwert überschreiten, der durch die Grenzbeanspruchungen, die einen Bruch des empfindlichen Elements hervorrufen, bestimmt ist.

2. Hydrophon nach Anspruch 1, wobei dieser Träger eine Honigwabenstruktur hat.

3. Hydrophon nach Anspruch 1, dadurch gekennzeichnet, daß diese Hohlräume durch Entfernung von Material hergestellt sind.

4. Hydrophon nach Anspruch 1, dadurch gekennzeichnet, daß diese Hohlräume durch Prägen hergestellt sind.

5. Hydrophon nach einem der vorhergehenden Ansprüche, dadurch gekennzeichnet, daß der Träger spiralartig mit aneinander anliegenden Windungen gewickelt ist.

6. Hydrophon nach Anspruch 1 oder 5, dadurch gekennzeichnet, daß es zwei empfindliche, jeweils in Kontakt mit den Flächen ein und des gleichen Trägers angeordnete Elemente umfaßt, wobei dieser Träger durchbrochen ist und seine Dicke derart gewählt ist, daß die empfindlichen Elemente sich gegeneinander abstützen, wenn die ausgeübten Beanspruchungen einen bestimmten Schwellenwert überschreiten.

**FIG.1**

**FIG.4**

**FIG.2**

**FIG.3**

**FIG.5**

**FIG.6**